(19) Europäisches Patentamt
European Patent Office
Office européen des brevets

(11) **EP 2 278 631 A1**

(12) **EUROPÄISCHE PATENTANMELDUNG**

(43) Veröffentlichungstag:
26.01.2011 Patentblatt 2011/04

(51) Int Cl.:
*H01L 31/052* (2006.01)

(21) Anmeldenummer: 09009379.0

(22) Anmeldetag: **20.07.2009**

(84) Benannte Vertragsstaaten:
AT BE BG CH CY CZ DE DK EE ES FI FR GB GR HR HU IE IS IT LI LT LU LV MC MK MT NL NO PL PT RO SE SI SK SM TR
Benannte Erstreckungsstaaten:
AL BA RS

(71) Anmelder: **Fraunhofer-Gesellschaft zur Förderung der angewandten Forschung e.V. 80686 München (DE)**

(72) Erfinder:
• **Bösch, Armin 79285 Ebringen (DE)**

• **Jaus, Joachim, Dipl.-Wi.-Ing. 79098 Freiburg (DE)**
• **Bett, Andreas, Dr. 79114 Freiburg (DE)**
• **Peharz, Gerhard, Mag. 79102 Freiburg (DE)**
• **Nitz, Peter, Dr. 79194 Gundelfingen (DE)**
• **Schmidt, Thomas 79098 Freiburg (DE)**

(74) Vertreter: **Pfenning, Meinig & Partner GbR Patent- und Rechtsanwälte Theresienhöhe 13 80339 München (DE)**

(54) **Solarzellenbaugruppe sowie Solarzellenanordnung**

(57) Die Erfindung betrifft eine Licht absorbierende beziehungsweise Licht emittierende Solarzellenbaugruppe sowie eine Solarzellenanordnung, die aus 2 bis 10.000 der erfindungsgemäßen Solarzellenbaugruppen aufgebaut ist.

FIG. 1

EP 2 278 631 A1

**Beschreibung**

Die Erfindung betrifft eine Licht absorbierende beziehungsweise Licht emittierende Solarzellenbaugruppe sowie eine Solarzellenanordnung, die aus 2 bis 10.000 der erfindungsgemäßen Solarzellenbaugruppen aufgebaut ist.

In der Photovoltaik wird Licht mittels Solarzellen in elektrische Energie umgewandelt. Bei der konzentrierenden Photovoltaik wird ein optisches System (beispielsweise mit Linsen oder Spiegeln) eingesetzt, das Licht auf Solarzellen konzentriert. Dabei ist sicherzustellen, dass möglichst viel Licht auf die Solarzelle fällt, da Licht, das neben die Solarzelle fällt, nicht in elektrische Energie umgewandelt werden kann.

In einem photovoltaischen Konzentratormodul werden mehrere Solarzellen zusammengefasst und elektrisch verschaltet. Die Solarzellen müssen vor Feuchtigkeit und mechanischen Belastungen geschützt werden. Dazu werden Solarzellen in der Regel verkapselt. Verkapselung heißt im vorliegenden Kontext zunächst eine Umschließung mit einem Material, das die verkapselte Solarzelle vor schädlichen Einflüssen schützt und gleichzeitig die Funktion möglichst wenig beeinträchtigt.

Konzentratormodule können diffuses Licht in der Regel kaum verwerten, da nur direktes (hinreichend paralleles) Licht konzentriert werden kann. Zusätzlich muss ein Konzentratormodul zur Sonne ausgerichtet sein, andernfalls würden konzentrierende Lichtstrahlen nicht auf die Solarzelle fallen. Daher werden Konzentratormoleküle meist auf einer Nachführung montiert, welche die Module zur Sonne ausrichten.

Der Quotient aus optischer Aperturfläche und Solarzelle wird als (geometrischer) Konzentrationsfaktor bezeichnet. Für ein Konzentratorsystem ist ein großer Konzentrationsfaktor wünschenswert. Zur Realisierung von hochkonzentrierenden Photovoltaiksystemen (Konzentrationsfaktor > 300) bietet sich der Einsatz von Sekundäroptiken an. Dabei wird ein zweistufiges Optikkonzept benutzt, das aus einer so genannten Primäroptik und einer Sekundäroptik besteht. Dieses zweistufige Konzept ermöglicht einen größeren Gestaltungsspielraum bei der Realisierung der Optik und der Modulgeometrie und erlaubt zudem höhere Konzentrationsfaktoren bzw. größere Toleranzen hinsichtlich der Positionierung in der Fertigung, Justage und Ausrichtung zur Sonne. Je nach Ausführung kann durch eine Sekundäroptik das auf die Empfängerfläche einfallende Licht zusätzlich homogenisiert werden, also eine Verbesserung der Gleichmäßigkeit der einfallenden Intensität erzielt werden, was nachfolgend als potenzieller Vorteil einer Sekundäroptik immer mit vorliegt, auch wenn es nicht explizit aufgeführt ist.

Sekundäroptiken für Konzentratormodule werden z.B. als reflektives Element, häufig aber als refraktives Bauelement ausgeführt. Bei erstem wird das Licht durch (Oberflächen-)Reflexion, bei letzterem mittels Brechung bzw. interner Totalreflexion auf die Solarzelle gelenkt. Bekannt sind für Sekundäroptiken Bauteilformen wie z.B. konisch zulaufende Lightguides, Pyramidenstümpfe, Kegelstümpfe, Quader, Zylinder, Linsen oder Parabole.

Es sind auch Kombinationen dieser Formen bekannt. Refraktive Sekundäroptiken (die nachfolgenden Ausführungen beziehen sich auf diesen Typus) müssen aus hochtransparenten Materialien wie Glas oder transparenten Kunststoffen (PMMA, Polycarbonat etc.) gefertigt sein, um möglichst wenig Licht zu absorbieren. Licht, das in der Sekundäroptik absorbiert wird, kann nicht von der Solarzelle genutzt werden. Zusätzlich befindet sich die Sekundäroptik meist im Fokus der Primäroptik und ist somit konzentrierter Sonnenstrahlung ausgesetzt. Selbst eine geringe Absorption der konzentrierten Sonnenstrahlung kann daher zu einem starken Aufheizen der Sekundäroptik und letztendlich zu deren Zerstörung führen. Je nach Verbindung zwischen Sekundäroptik und Zelle wird auch die Zelle erwärmt, was unerwünscht ist. Zur Vermeidung von optischen Verlusten an der Grenzfläche zwischen Sekundäroptik und Solarzelle wird dieser Bereich häufig mit einem optischen Ankoppelmedium gefüllt. Dabei tritt bei der Verwendung von Sekundäroptiken, die interne Totalreflexion (TIR) benutzen, folgendes Problem auf:

Das optische Ankoppelmedium kann die äußeren Oberflächen von Sekundäroptiken benetzen, wodurch die Oberflächenkontur derart verändert wird, dass die Bedingungen für TIR nicht mehr gegeben sind. So wird Licht an diesen benetzten Oberflächen ausgekoppelt und fällt nicht mehr auf die Solarzelle. Auch ist die Montage von Sekundäroptiken häufig nicht trivial zu lösen. Die bekannten Methoden zur Montage benötigen meist zusätzliche Haltevorrichtungen für die Sekundäroptiken, durch die Material- und Prozesskosten erhöht werden.

Befindet sich Verkapselmaterial im Strahlengang, gilt ähnliches wie für das Sekundäroptikmaterial. Das Material für die Solarzelle muss hochtransparent für Solarstrahlung (300-2000 nm) sein. Im Kapselmaterial absorbiertes Licht kann nicht in elektrische Energie umgewandelt werden. Außerdem führt schon eine geringe Absorption von konzentriertem Sonnenlicht zu einer starken Erwärmung des Materials, was zu Degradation und letztendlich zu dessen Zerstörung führen kann. Da sich das Medium im Brennpunkt der Primäroptik befindet, ist es erforderlich, dass das eingesetzte Material zudem stabil gegen hohe Strahlungsdosen ist.

Es ist wichtig, dass das Material die Solarzelle vor Umwelteinflüssen wie z.B. Luftfeuchtigkeit schützt. Aus den genannten Gründen werden in der Regel transparente Silikone zur Verkapselung eingesetzt. Dazu wird das Kapselmaterial in flüssigem Zustand auf und um die Zelle aufgetragen und anschließend ausgehärtet. Weiterhin ist es möglich, dass Silikon, das zur optischen Ankopplung zwischen Sekundäroptik und Solarzelle verwendet wird, auch dem Schutz der Solarzellenränder dient. Der Nachteil speziell von hochtransparentem Silikon ist, dass es auf vielen Oberflächen nur unzureichend haftet und durchlässig für Wasserdampf ist. Daher sind hochtransparente Silikone nur begrenzt für die Verkapselung von Solarzellen geeignet.

Der oben aufgeführte Stand der Technik weist explizit die folgenden Nachteile auf:

- Für die Montage von Sekundäroptiken mit einer größeren Eingangsapertur als Ausgangsapertur werden Zusatzhalterungen benötigt, die die Material- und Prozesskosten für Konzentratormodule erhöhen.

- Optische Ankoppelmedien können die Seitenflächen von Sekundäroptiken benetzen, was bei der Verwendung von interner Totalreflexion zu einer Auskopplung von Licht führt.

- Als Kapselmaterialien kommen immer nur hochtransparente Materialien in Frage. Wird im Kapselmaterial konzentrierte Sonnenstrahlung absorbiert, kann dies zur Zerstörung der Verkapselung führen. Die Verwendung von ausschließlich hochtransparenten Materialien schränkt die Materialauswahl sehr stark ein.

Außer den oben beschriebenen Bauteilen speziell für die konzentrierende Photovoltaik, sind nach dem Stand der Technik Leuchtdioden-Bauteile (LED) bekannt. Ähnlich wie bei der Anwendung für photovoltaische Konzentratorsysteme, werden bei Leuchtdioden-Bauteilen Halbleiterelemente mit einer Optik kombiniert, wobei gleichzeitig die Verkapselung der elektrischen Elemente sichergestellt wird. Die vorliegende Erfindung grenzt sich von LED-Bauteilen in folgenden Punkten ab:

- Bei LED-Bauteilen tritt Licht meist seitlich aus dem Halbleiter aus. Bei der photovoltaischen Anwendung tritt Licht über die Vorderseite in den Halbleiter ein. Dieser Unterschied spiegelt sich auch in der elektrischen Kontaktierung der Halbleiter-Elemente wieder. Während bei der LED-Technik die gesamte Vorderseite als Kontaktierfläche dient, muss bei der Photovoltaik darauf geachtet werden, dass die Verschattung durch die Kontaktierung minimal ist.

- Bei der LED-Anwendung werden Füllstoffe in der Kapselmasse verwendet um das Spektrum des austretenden Lichts zu beeinflussen. Bei der photovoltaischen Anwendung muss die (beleuchtete) Kapselmasse möglichst transparent sein.

- Speziell die konzentrierende Photovoltaik stellt spezielle Anforderungen, die mit Bauteilen aus der LED-Technik nicht lösbar sind. Im Gegensatz zur LED-Anwendung kommt es bei der konzentrierenden Photovoltaik zu lokalen Lichtintensitäten > 1000 kW/m$^2$. Würden LED-Bauteile, die aus dem Stand der Technik bekannt sind, in der konzentrierenden Photovoltaik eingesetzt, würden diese in der Regel zerstört. Zusätzlich spielen Kosten bei der LED-Anwendung in der Regel eine geringere Rolle als bei der Photovoltaik. Daher werden bei LED-Bauteilen häufig zusätzliche Elemente (beispielsweise Haltevorrichtungen) benutzt, die für die Anwendung in einem Konzentratormodul zu teuer wären.

Ausgehend hiervon ist es Aufgabe der vorliegenden Erfindung, die optischen Eigenschaften eines Konzentratormoduls mithilfe einer entsprechenden Sekundäroptik zu verbessern und kostengünstiger zu ermöglichen. Diese Aufgabe wird gelöst durch die Licht absorbierende und/oder Licht emittierende Solarzellenbaugruppe gemäß Anspruch 1. Anspruch 28 bezieht sich auf eine Solarzellenanordnung. Weitere vorteilhafte Ausführungsformen sind in den abhängigen Ansprüchen enthalten.

Erfindungsgemäß wird eine Licht absorbierende und/oder Licht emittierende Solarzellenbaugruppe bereitgestellt, die einen auf einem elektrisch leitfähigen Substrat angeordneten elektrischen Isolator umfasst, der mit einer metallisierten Oberfläche versehen ist, und mindestens einer Solarzelle mit einer refraktiven Sekundäroptik, die mit dem elektrisch leitfähigem Substrat verbunden ist, wobei die Solarzelle in einer Ausnehmung in dem mit der metallisierten Oberfläche versehenen Isolator angeordnet ist und wobei die Solarzelle mit der dem Substrat zugewandten Seite über eine elektrisch leitfähige Verbindung mit dem Substrat verbunden ist und die Ausnehmung so dimensioniert ist, dass seitlich zwischen der Solarzelle und dem mit der metallisierten Oberfläche versehenen elektrischen Isolator ein Zwischenraum entsteht, der mit einem Kopplungsmedium gefüllt ist und die Solarzelle mit mindestens einem elektrischen Kontakt mit der metallisierten Oberfläche verbunden ist.

Die Erfindung umfasst dabei Ausführungsformen, bei denen die Solarzelle vollständig in dem durch die Ausnehmung gebildeten Hohlraum angeordnet ist, wie auch Ausführungsformen, bei denen die Solarzelle teilweise über die metallische Oberfläche des Isolators hinausragt.

Durch die hier vorgeschlagene Sekundäroptik wird Licht auf die Solarzelle gelenkt, das andernfalls neben die Solarzelle fallen würde. Weiterhin wird durch die Sekundäroptik Licht aus einem größeren Raumwinkel für die Solarzelle verwertbar gemacht. Dadurch, dass die Solarzelle wie auch gegebenenfalls der elektrische Kontakt vollständig verkapselt sind, wird die Solarzelle vor allem vor Staub, Feuchtigkeit, korrosiven Gasen und mechanischen Belastungen geschützt, wodurch die Langzeitstabilität der Solarzellenbaugruppe erhöht ist.

Als Solarzellen für die Solarzellenbaugruppe (engl. Solar Cell Assembly, SCA) können hier sämtliche bekannte Solarzellen eingesetzt werden. Weiterhin können auch monolithische Mehrfachsolarzellen, speziell eine Dreifachsolarzelle mit einer monolithischen Mehrfachsolarzelle eingesetzt werden. Die Solarzellen können weiterhin mit Elementen aus der III. und V. Hauptgruppe dotiert sein.

Der Erfindungsgegenstand besteht in der Verbesserung der bekannten Solarzellenbaugruppen durch den Einsatz einer integrierten Sekundäroptik. Vorteile dieser Solarzellenbaugruppe sind die gute Ableitung der von der Solarzelle ausgehenden Wärme, der Schutz der Solarzelle vor Korrosion, der Resistenz bzw. Schutz aller verwendeten Elemente gegen die konzentrierte Solarstrahlung, die Langzeitbeständigkeit des gesamten Aufbaus, die Verwendung möglichst kostengünstiger Ausgangsmaterialien sowie der Ausgleich der im Betrieb entstehenden thermischen Spannungen.

Für den Prozess zur Herstellung einer erfindungsgemäßen Solarzellenbaugruppe mit integrierter, refraktärer Sekundäroptik fallen geringe Material- und Prozesskosten an. Weiterhin ist eine hohe Positionierungsgenauigkeit der Sekundäroptik relativ zur Solarzelle gewährleistet wie auch eine Vermeidung von Beschädigung der Solarzellen, der Sekundäroptik oder anderer auf der Solarzellenbaugruppe vorhandenen Elemente im Bestückungsvorgang.

Bevorzugt ist das Kopplungsmedium ausgewählt aus der Gruppe bestehend aus transparenten Materialien, Silikonen, Silikonöl, Polycarbonaten, Polyacrylaten, Poly(meth)acrylaten, Glas, Quarzglas, thermoplastischen Kunststoffen und Mischungen hiervon. Diese Materialien sind genau dosierbar und daher hervorragend auch in schmale Bereiche einfüllbar.

Das Kopplungsmedium kann auch die Solarzelle und den elektrischen Kontakt vollständig verkapseln. Dadurch sind die Solarzelle und der mindestens eine elektrische Kontakt optimal vor destruktiven Umgebungseinflüssen, wie z.B. Feuchtigkeit oder korrosiven Gasen, geschützt. Folglich erhöht sich auf diese Weise die Langzeitstabilität der erfindungsgemäßen Solarzellenbaugruppe. Auch eine Vereinfachung der Fertigung kann so ermöglicht werden, da in nur einem Arbeitsschritt das Kapselmedium aufgetragen werden kann.

Weiterhin kann die elektrisch leitfähige Verbindung der Solarzelle mit dem Substrat mittels Kleber, Lot, Bondverbindung und/oder Schweißen erfolgen. Diese lassen sich punktgenau aufbringen und weisen eine hohe Stabilität auf.

Die metallisierte Oberfläche der Solarzellenbaugruppe kann aus Metallen, insbesondere Kupfer, Silber, Nickel, Gold, Platin, Titan, Palladium, Aluminium bzw. Germanium-Legierungen bestehen oder diese enthalten. Diese Materialien eigenen sich besonders gut für eine Kontaktierung und können auch als Verschaltungspad dienen.

Bevorzugt besteht das Substrat für die Solarzellenbaugruppe aus Kupfer, Aluminium, Titan, Stahl, Silizium-Legierungen oder Metall-Legierungen. Durch diese Substrate ist eine optimale Wärmeleitung gewährleistet, die eine gute Ableitung der von der Solarzelle ausgehenden Wärme ermöglicht. Somit ist eine Zerstörung der Solarzellenbaugruppe aufgrund von thermischen Spannungen praktisch unmöglich. Das Substrat kann auch aus isolierenden Materialien, wie sie z.B. nachfolgend beim Isolator beschrieben sind, bestehen, sofern die Oberfläche elektrisch leitend ist. Als elektrisch leitfähige Materialien für die Oberflächenbeschichtung kommen die vorstehend beschriebenen in Frage.

Der elektrische Isolator besteht vorzugsweise aus Epoxidharzen, thermoplastischen Kunststoffen, Keramiken, Aluminiumoxid, Polyethylenen, Polyvinylchloriden, Polytetrafluorethylenen, Silikonen oder Glas. Diese Materialien sind inert und verbessern folglich die Langzeitstabilität.

In einer alternativen Variante der Erfindung weist die Solarzelle zumindest auf der mit der Sekundäroptik verbundenen Seite zumindest eine Schutzbeschichtung aus einem optisch transparenten Metall, aus Aluminiumoxid, Silizium, Siliziumoxid, Siliziumnitrid, Siliziumcarbid, Polycarbonaten, Poly(meth)acrylaten, Silikon, Glas, Quarzglas oder thermoplastischen Kunststoffen auf.

Weiterhin kann die Solarzellenbaugruppe dadurch gekennzeichnet sein, dass die refraktive Sekundäroptik zur Fokussierung von Sonnenlicht auf der Solarzelle umfassend ein aus einem optisch transparenten dielektrischen Material mit einer mittleren Transmittivität von mindestens 90 % im Wellenlängenbereich zwischen 400 und 2500 nm, gemessen bei einer Schichtdicke von 1 mm massiv ausgebildeten Refraktor, der eine dem Sonnenlicht zugewandte Eintrittsapertur und eine der Solarzelle zugewandte Austrittsapertur aufweist, wobei die Eintritts- und/oder die Austrittsapertur so ausgestaltet ist, dass eine refraktive Konzentration des einfallenden Sonnenlichts erfolgt.

Bevorzugt ist das optisch transparente dielektrische Material für die Sekundäroptik ausgewählt aus der Gruppe bestehend aus Epoxidharz, Silikon, Silikonharz, Polycarbonat, Polyacrylaten, Poly(meth)acrylaten, Glas, Quarzglas, thermoplastische Kunststoffen, Siliziumoxid, Siliziumcarbid, Aluminiumoxid und Mischungen hiervon. Durch die Witterungsbeständigkeit der eingesetzten Verbindungen wie auch eine geringe Absorption des einfallenden Lichts eignen sich die genannten Materialien besonders gut.

Die Eintritts- und/oder Austrittsapertur der Sekundäroptik kann eine flache, konvexe und/oder konkave Oberflächenkontur aufweisen. Welche Oberflächenkontur gewählt wird, hängt unter Anderem von den verwendeten Materialien ab. Die refraktive Sekundäroptik kann hierbei verschiedenste Formen, wie z.B. Paraboloid, Kegelstumpf, Lightguide, Pyramidenstumpf etc. aufweisen.

Vorzugsweise ist die Fläche der Eintrittsapertur der Sekundäroptik größer als die Fläche der Austrittsapertur der Sekundäroptik. Je größer der Quotient aus Fläche der Eintrittsapertur zu Fläche der Austrittsapertur ist, umso höher ist der Konzentrationsfaktor der Sekundäroptik.

Die refraktive Sekundäroptik kann eine den Refraktor umschließende Auskragung aufweisen, die bevorzugt auf Höhe der Eintrittsapertur angeordnet ist und weiter bevorzugt monolithisch oder formschlüssig mit dem Refraktor verbunden ist. Durch die Auskragung wird beispielsweise eine Vereinfachung bei der Montage von Sekundäroptiken mittels Pick & Place-Verfahren ermöglicht, da diese Optiken einfach maschinengreifbar sind.

Weiterhin kann der Refraktor mit Ausnahme der Bereiche der Eintritts- und Austrittsapertur und/oder die der Austrittsapertur zugewandte Seite der Auskragung mit einer hochreflektiven Beschichtung mit einem Reflexionsgrad p > 70 % in einem Wellenlängenbereich von 400 bis 800 nm und/oder einem Reflexionsgrad p > 80 % in einem Wellenlängenbereich von 900 bis 2500 nm beschichtet sein. Die Beschichtung ermöglicht eine hervorragende Konzentration des einfallenden Lichts auf die Solarzelle, ohne dass das Licht auf die Umgebung der Solarzelle auftrifft. So werden eine Aufwärmung und ein damit verbundener Strahlungsverlust unterbunden. Weiterhin kann auch nicht-transparentes Kapselmaterial eingesetzt werden.

Die hochreflektive Beschichtung der Sekundäroptik enthält vorzugsweise ein Metall, insbesondere Aluminium, bevorzugt in hochreiner (> 99 Gew.-%) Form, oder Silber, und/oder eine Schichtfolge von Materialien mit unterschiedlichen Brechungsindices $n_D^{20}$ und/oder Legierungen oder besteht hieraus. Diese Beschichtung bzw. Schichtfolge kann auch eine Schutzfunktion oder -schicht beinhalten.

Die hochreflektive Beschichtung der Sekundäroptik kann eine Schichtdicke von 1 nm bis 3 mm, bevorzugt von 1 µm bis 200 µm aufweisen. Dadurch wird nur wenig Material benötigt und dennoch die Reflexion und damit die Lichtkonzentration auf die Solarzelle effektiv erhöht.

In einer alternativen Ausführungsform der Solarzellenbaugruppe ist der Refraktor mittels eines Verbunds durch Verklebung und/oder mechanische Fixierung auf der metallisierten Oberfläche fixiert. Dadurch wird die Stabilität der Solarzellenbaugruppe gegen äußere Bedingungen zusätzlich verbessert.

Das Material für die Ausbildung des Verbunds kann hierbei ausgewählt sein aus der Gruppe bestehend aus thermoplastischen Kunststoffen, Epoxidharzen, Silikonen, Acrylaten, Cyanacrylaten, Polycarbonaten, Polyacrylaten, Poly(meth)acrylaten und Mischungen hiervon. Diese Verbundmasse muss nicht transparent sein.

Bevorzugt ist das Material für die Ausbildung des Verbunds ein thermisch leitendes Material, das elektrisch isolierend ist. Dadurch wird einerseits eine Überhitzung der Solarzellenbaugruppe, andererseits das Auftreten eines Kurzschlusses unterbunden. Das Verbundmaterial kann weiterhin auch zur Einkapselung des elektrischen Kontakts dienen.

Weiterhin kann das Material für den Verbund und das Kopplungsmedium identisch sein. So wird die Fertigung, die auch mittels Pick & Place-Verfahren erfolgen kann, vereinfacht, da nur ein Schritt für die Applizierung von Verbundmaterial und Kopplungsmedium, das in diesem Falle identisch ist, benötigt wird. Das Material für die Ausbildung des Verbunds kann vollständig von der Auskragung der Sekundäroptik verdeckt sein. Dadurch wird der Einfluss von Umgebungsbedingungen (wie z.B. Sonnenstrahlung) auf das Verbundmaterial, der z.B. eine Versprödung des Materials bewirken könnte, effektiv unterbunden.

Bevorzugt ist die refraktive Sekundäroptik von einer Ummantelung formschlüssig eingefasst, wobei die Oberseite der Ummantelung die Eintritts- und die Unterseite der Ummantelung die Austrittsapertur bildet. Die Ummantelung kann beispielsweise eine kreisförmige, ovale oder eckige Grundfläche aufweisen und folglich zylinderförmig oder prismenförmig sein. Bevorzugt ist die Ummantelung zylinderförmig.

Die refraktive Sekundäroptik kann eine konvex ausgebildete Eintrittsapertur aufweisen, die die Ummantelung in Längsrichtung überragt. Somit wird auf einfache Weise eine linsenförmige Eintrittsapertur zur Konzentration des einfallenden Lichts gebildet.

Die Sekundäroptik kann über mindestens ein Befestigungselement mit der Solarzelle und/oder dem Substrat verbunden sein. Weiterhin kann das Substrat mindestens eine formschlüssige, reversible Arretierung aufweisen, mit der mindestens ein Befestigungselement verbindbar ist.

In einer bevorzugten Ausführungsform ist mindestens eine Schutzdiode und/oder mindestens eine Primäroptik zur Konzentration von Licht auf die Sekundäroptik, wie z.B. ein Fresnel-Kollektor, eine Linse und/oder ein Spiegel in der Solarzellenbaugruppe enthalten. Diese Komponenten dienen einer ersten Fokussierung des Lichts auf die Sekundäroptik.

In einer Variante der Solarzellenbaugruppe ist die Solarzelle mit mindestens einer weiteren Solarzelle über den mindestens einen Kontakt elektrisch seriell und/oder parallel verschaltet.

Weiterhin umfasst die Erfindung eine Sollarzellenanordnung, die dadurch gekennzeichnet ist, dass sie aus 2 bis 10.000 der beschriebenen Solarzellenbaugruppen aufgebaut ist.

Sowohl die Solarzellenbaugruppe als auch die Solarzellenanordnung können auf Nachführungen angeordnet sein.

Anhand der folgenden Figuren 1 bis 3 und Beispiele 1 bis 3 soll der anmeldungsgemäße Gegenstand näher erläutert werden, ohne ihn auf diese Varianten einzuschränken.

Figur 1    zeigt eine Solarzellenbaugruppe mit einer refraktiven Sekundäroptik, die eine Auskragung aufweist.

Figur 2    zeigt eine Solarzellenbaugruppe mit einer refraktiven Sekundäroptik, die eine konvexe Eintrittsapertur aufweist.

Figur 3    zeigt eine Solarzellenbaugruppe, die eine ummantelte refraktive Sekundäroptik auf- weist.

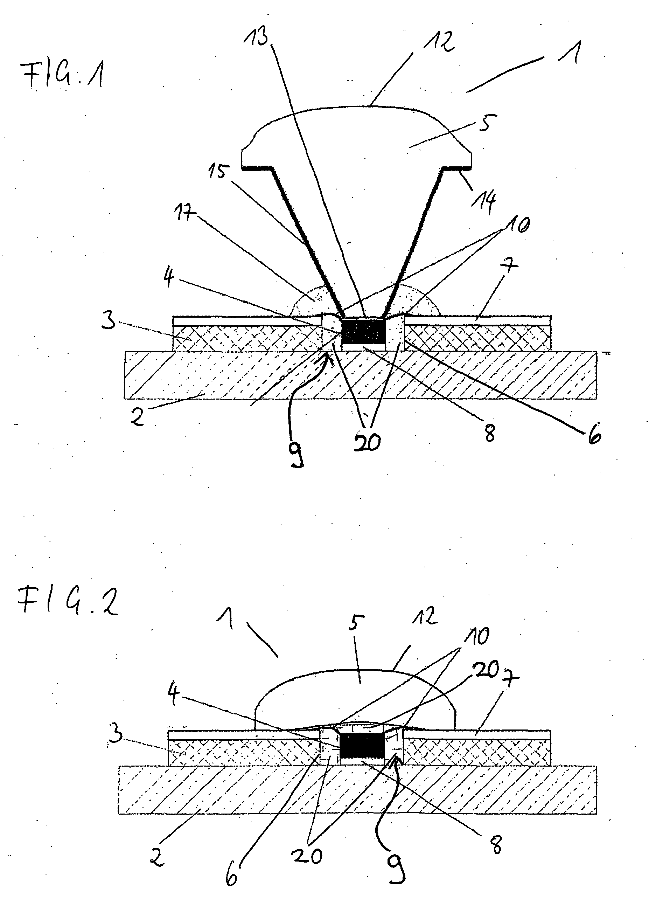

Figur 1 zeigt eine Solarzellenbaugruppe 1 aus
einem elektrisch leitfähigen Substrat 2, das als Wärmesenke dient und aus Kupfer ist. Die Solarzelle 4 ist eine
III-V Mehrfachsolarzelle. Die metallisierte Oberfläche 7
aus einer Cu/Ni/Au-Schichtenfolge auf dem Isolator 3
dient als Kontaktpad und weist in der Mitte eine Ausnehmung 6 auf. Die refraktive Sekundäroptik 5 ist ein Glaskörper, der als Kegelstumpf mit linsenförmiger Eintrittsapertur 12 ausgebildet ist. Die Austrittsapertur 13 hat
hierbei dieselbe Form und Dimension wie die Solarzelle
4. Die Mantelfläche des Kegelstumpfs ist mit einer silberhaltigen, hochreflektiven Beschichtung mit zusätzlicher Schicht als Schutzschicht 15 versehen und so vor
Umwelteinflüssen geschützt. An der Seite der Eintrittsapertur 12 besitzt die Sekundäroptik 5 eine Auskragung
14, die das Greifen beim Pick & Place-Verfahren erleichtert und zusätzlichen Schutz für die spätere Verkapselung durch das Material für den Verbund 17 bietet. Die
Sekundäroptik 5 kann in einem Glaspressverfahren (allgemeiner: Glasheißformgebung) hergestellt werden,
wobei idealerweise mehrere Optiken in einem Pressvorgang hergestellt werden. Dadurch kann die Prozesszeit
verkürzt werden.

Die Solarzelle 4 wird mit elektrisch leitfähigem
Kleber 8 auf die Solarzelle 4 montiert. Alternativ kann die
Solarzelle 4 aufgelötet werden. Dadurch wird über das
Kupferplättchen 2 der Rückseitenkontakt der Solarzelle
4 hergestellt. Der elektrische Isolator 3 mit der metallisierten Oberfläche 7 wird auf die Wärmesenke 2 geklebt,
so dass sich die Solarzelle 4 in der Mitte der Ausnehmung
6 befindet. In einem Bondverfahren wird mit Dünndrahtbond (idealerweise Golddraht) ein elektrischer Kontakt
10 zwischen der Solarzellenvorderseite und der metallisierten Oberfläche 7 hergestellt.

Auf die Solarzellenvorderseite oder die Austrittsapertur 13 wird eine kleine Menge optisches Ankoppelmaterial 20 aufgebracht. Dazu kann flüssiges transparentes Silikon verwendet werden. Die Sekundäroptik
5 wird mit der Austrittsapertur 13 auf die Solarzellenoberseite aufgesetzt. Anschließend wird das Material für den
Verbund 17 um die Solarzelle 4 und die Sekundäroptik
5 aufgebracht, wobei auch die elektrische Kontaktierung
10 verkapselt wird. Für den Verkapselungsprozess eignet sich unter anderem ein Spritz- oder Dispensverfahren. Abschließend wird die Kapselmasse 20 ausgehärtet. Im Beispielsfall der Figur 1 ist dabei das Material für
den Verbund 17 und das Kopplungsmedium 20 identisch.
Dadurch wird ein einfacher und kostengünstiger Prozess
möglich, da nur ein Material erforderlich ist.

In Figur 2 ist eine Solarzellenbaugruppe 1 mit
einer refraktiven Sekundäroptik 5, die eine konvexe Eintrittsapertur 12 aufweist, dargestellt. Ein elektrisch leitfähiges Substrat 2 dient als Wärmesenke und besteht aus
Kupfer. Die Solarzelle 4 ist eine III-V Mehrfachsolarzelle.
Die metallisierte Oberfläche 7 aus einer Cu/Ni/Au-Schichtfolge auf dem Isolator 3 dient als Kontaktpad und
weist in der Mitte eine Ausnehmung 6 auf. Die Sekundäroptik 5 ist ein Glaskörper in Zylinderform mit konvexer,
linsenförmiger Eintrittsapertur 12 und flacher Autrittsapertur 13. Sowohl die Eintrittsapertur 12 als auch die Austrittsapertur 13 sind größer als die Oberfläche der Solarzelle 4. Die Sekundäroptik 5 kann in einem Glaspressverfahren hergestellt werden, wobei idealerweise mehrere
Optiken in einem Pressvorgang hergestellt werden. Dadurch kann die Prozesszeit verkürzt werden. Die Solarzelle 4 wird mit elektrisch leitfähigem Kleber 8 auf der
Solarzelle 4 montiert. Dadurch wird über das Kupferplättchen 2 der Rückseitenkontakt der Solarzelle 4 hergestellt. Der elektrische Isolator 3 mit der metallisierten
Oberfläche 7 wird auf die Wärmesenke 2 geklebt, so dass
sich die Solarzelle 4 in der Mitte der Ausnehmung 6 befindet. In einem Bondverfahren wird mit Dünndrahtbond
(idealerweise Golddraht) ein elektrischer Kontakt 10 zwischen der Solarzellenvorderseite und der metallisierten
Oberfläche 7 hergestellt.

Es wird transparentes und flüssiges Silikon 20
in den Zwischenraum 9 zwischen Solarzelle 4 und Isolator 3 gefüllt, so dass etwas von dem Silikon aus dem
Zwischenraum 9 austritt. In dieses austretende Silikon
20 wird die Sekundäroptik 5 mit der Austrittapertur 13
gedrückt, so dass ein optischer Kontakt hergestellt wird.
Die Solarzelle 4 ist hier vollständig von dem Kopplungsmedium 20 eingekapselt. Der Abstand zwischen der Austrittsapertur 13 der Sekundäroptik 5 und der Solarzelle 4
wird durch die Dicke des Isolators 3 bestimmt und beeinflusst das Gesamtdesign der Konzentratoroptik. Abschließend wird das Silikon ausgehärtet.

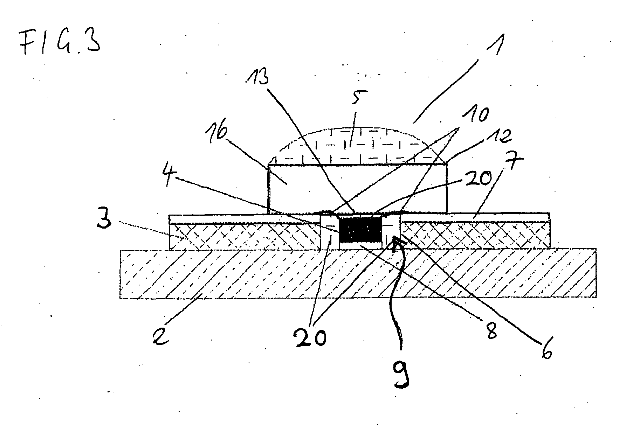

Figur 3 zeigt eine Solarzellenbaugruppe 1, die
eine ummantelte refraktive Sekundäroptik 5 aufweist.
Das elektrisch leitfähige Substrat 2 als Wärmesenke besteht aus Kupfer. Die Solarzelle 4 ist eine III-V Mehrfachsolarzelle. Die metallisierte Oberfläche 7 aus einer
Cu/Ni/Au-Schichtfolge auf dem Isolator 3 dient als Kontaktpad und weist in der Mitte eine Ausnehmung 6 auf.
Der Metallzylinder aus Aluminium als Ummantelung 16
besitzt einen größeren Innendurchmesser als die Ausnehmung 6. Der Zwischenraum 9 zwischen der Solarzelle 4 und dem Isolator 3, der mit einer metallisierten
Oberfläche 7 versehen ist, ist mit Kopplungsmedium 20
gefüllt.

Die Solarzelle 4 wird mit elektrisch leitfähigem
Kleber 8 auf der Solarzelle 4 montiert. Alternativ kann
die Solarzelle 4 auch aufgelötet werden. Dadurch wird
der Rückseitenkontakt zwischen Solarzelle 4 und Kupferplättchen 2 hergestellt. Die metallisierte Oberfläche 7
aus einer Cu/Ni/Au-Schichtfolge auf dem Isolator 3 dient
als Kontaktpad und weist in der Mitte eine Ausnehmung
6 auf. In einem Bondverfahren wird mit Dünndrahtbond
(idealerweise Golddraht) ein elektrischer Kontakt 10 zwischen der Solarzellenvorderseite und der metallisierten
Oberfläche 7 hergestellt. Der Aluminium-Hohlzylinder 16
wird auf die metallisierte Oberfläche 7 gesetzt, so dass
die Achse der Ummantelung 16 durch die Mitte der Solarzelle 4 verläuft. Zur Erhöhung der Stabilität kann der Hohlzylinder 16 auch festgeklebt werden. In den AluminiumZylinder 16 wird transparentes und flüssiges Silikon 5 gefüllt, bis es beginnt aus dem Zylinder 16 auszutreten bzw. sich über die offene Stirnfläche des Zylinders 16 hinauszuwölben. Durch die Oberflächenspannung des Silikons stellt sich eine gekrümmte Oberfläche ein, deren endgültige Form durch die Füllmenge, die Temperatur bei Füllung, Aushärtung und Nutzung) und eine mögliche Formänderung bei der Aushärtung (z.B. Volumenschrumpf) bestimmt wird. Das gesamtoptische Design der Solarzellenbaugruppe 1 entscheidet, welche Oberflächenform eingestellt wird bzw. welche Höhe der Aluminiumzylinder 16 aufweisen muss. Anschließend wird das Silikon 5 ausgehärtet.

**Beispiel 1**

Es wird eine Sekundäroptik verwendet, wobei die Eintrittsapertur der Sekundäroptik größer ist als die Austrittsapertur. Die Sekundäroptik besteht aus einem transparenten Dielektrikum (beispielsweise Glas, PMMA, Polycarbonat etc.) und weist prinzipiell eine von der Eintrittsapertur zur Austrittsapertur zulaufende Form auf (beispielsweise Paraboloid, Kegelstumpf, Lightguide, Pyramidenstumpf etc.). Die Eintritts- und/oder Austrittsapertur kann flach oder gewölbt ausgeformt sein.

Die Seitenflächen der Sekundäroptik sind mit einer hoch reflektierenden, z.B. Silber enthaltenden, Schicht sowie mit Schutzschichten versehen, die diese hochreflektive Schicht schützen. Zur Montage der Sekundäroptik wird diese mit der Austrittsapertur auf die Solarzelle gesetzt (Pick & Place-Verfahren). Dabei kann der Zwischenraum zwischen Sekundäroptik und Solarzelle mit einem optischen Ankoppelmedium gefüllt werden.

Anschließend wird die Sekundäroptik verklebt. Dazu wird eine Klebe- bzw. Verbundmasse verwendet, welche die Außenseite der Sekundäroptik, die Ränder der Solarzelle und die elektrische Kontaktierung (Bond- oder Schweißverbindungen) umschließt. Dadurch wird sowohl die Montage der Sekundäroptik als auch die Verkapselung der Solarzelle und der elektrischen Verbindung bzw. Kontaktierung sichergestellt.

Da bei der verwendeten Sekundäroptik die Außenfläche mit einer metallischen Spiegelschicht versehen ist, muss die Kapsel- bzw. Klebemasse nicht transparent sein. Die Verkapselung wird durch die Sekundäroptik vor der konzentrierten Solarstrahlung geschützt. Zusätzlich kann die Sekundäroptik an der Oberseite über eine Auskragung verfügen (z.B. in Form eines umlaufenden Rings), der die Kapselmasse zusätzlich vor der konzentrierten Strahlung schützt. Eine derartige Auskragung kann weiterhin vorteilhaft für die Montage sein, bei der sie als greifbarer Bereich für das Pick & Place-Verfahren dient. Weiterhin kann die Auskragung verwendet werden um die Sekundäroptik zusätzlich mechanisch zu haltern.

**Beispiel 2**

Es wird eine linsenförmige Sekundäroptik verwendet. Die Sekundäroptik besteht aus einem transparenten Dielektrikum (beispielsweise Glas, PMMA, Polycarbonat etc.) und weist eine konvex geformte Eintrittsapertur auf. Konzentriertes Licht, das auf die Eintrittsapertur fällt, wird zusätzlich konzentriert bzw. Licht aus einem größeren (Einfalls-)Raumwinkel wird auf die Autrittsapertur gelenkt.

Das Kontaktpad zur Realisierung des Vorderseitenkontakts sollte die Solarzelle dabei vollständig umschließen. Zusätzlich sollte das Kontaktpad mindestens so dick sein wie die verwendete Solarzelle. Das Volumen zwischen Zelle und Kontaktpad wird mit Kapselmasse bzw. Kopplungsmedium etwas überfüllt, wobei eine kleine Menge dessen aus dem Volumen austritt. Die Sekundäroptik kann zusätzlich verklebt werden. Als Kapselmasse lässt sich beispielsweise transparentes Silikon einsetzen.

**Beispiel 3**

Es wird eine Sekundäroptik ausgebildet, indem eine zylinderförmige Ummantelung so platziert wird, dass sie die Solarzelle und die elektrischen Bond- bzw. Schweißverbindungen, die der elektrischen Kontaktierung dienen, einschließt. Anschließend wird das Volumen zwischen der Solarzelle und der Ummantelung mit optisch transparentem, dielektrischen Material ausgefüllt. Je nach Füllmenge und Benetzungscharakteristik des Materials lassen sich gekrümmte Oberflächen herstellen, die günstig in den Strahlengang eingreifen und Licht auf die Solarzelle lenken bzw. fokussieren. Das Material zur Verkapselung, z.B. aus transparentem Silikon, dient somit dem Schutz der Solarzelle und dem Schutz der elektrischen Kontaktierung.

**Patentansprüche**

1. Licht absorbierende und/oder Licht emittierende Solarzellenbaugruppe (1) umfassend einen auf einem elektrisch leitfähigen Substrat (2) angeordneten elektrischen Isolator (3), der mit einer metallisierten Oberfläche (7) versehen ist, und mindestens einer Solarzelle (4) mit einer refraktiven Sekundäroptik (5), die mit dem elektrisch leitfähigen Substrat (2) verbunden ist,
dadurch gekennzeichnet, dass die Solarzelle (4) in einer Ausnehmung (6) in dem mit der metallisierten Oberfläche (7) versehenen Isolator (3) angeordnet ist, wobei die Solarzelle (4) mit der dem Substrat (2) zugewandten Seite über eine elektrisch leitfähige Verbindung (8) mit dem Substrat (2) verbunden ist und die Ausnehmung (6) so dimensioniert ist, dass seitlich zwischen der Solarzelle (4) und dem mit der metallisierten Oberfläche (7) versehenen elektrischen Isolator (3) ein Zwischenraum (9) entsteht, der mit einem Kopplungsmedium (20) gefüllt ist und die Solarzelle (4) mit mindestens einem elektrischen Kontakt (10) mit der metallisierten Oberfläche (7) verbunden ist.

**2.** Solarzellenbaugruppe (1) gemäß dem vorhergehenden Anspruch,
**dadurch gekennzeichnet, dass** das Kopplungsmedium (20) ausgewählt ist aus der Gruppe bestehend aus transparenten Materialien, Silikonen, Silikonöl, Polycarbonaten, Polyacrylaten, Poly(meth)-acrylaten, Glas, Quarzglas, thermoplastischen Kunststoffen und Mischungen hiervon.

**3.** Solarzellenbaugruppe (1) gemäß einem der vorhergehenden Ansprüche,
**dadurch gekennzeichnet, dass** das Kopplungsmedium (20) die Solarzelle (4) und den mindestens einen elektrischen Kontakt (10) vollständig verkapselt.

**4.** Solarzellenbaugruppe (1) gemäß einem der vorhergehenden Ansprüche,
**dadurch gekennzeichnet, dass** die elektrisch leitfähige Verbindung (8) der Solarzelle (4) mit dem Substrat (2) mittels Kleber, Lot, Bondverbindung und/oder Schweißen erfolgt.

**5.** Solarzellenbaugruppe (1) gemäß einem der vorhergehenden Ansprüche,
**dadurch gekennzeichnet, dass** die metallisierte Oberfläche (7) aus Metallen, insbesondere Kupfer, Silber, Nikkel, Gold, Platin, Titan, Palladium, Aluminium; Germanium-Legierungen besteht oder diese enthält.

**6.** Solarzellenbaugruppe (1) gemäß einem der vorhergehenden Ansprüche,
**dadurch gekennzeichnet, dass** das Substrat (2) aus Kupfer, Aluminium, Titan, Stahl, Silizium-Legierungen oder Metall-Legierungen besteht.

**7.** Solarzellenbaugruppe (1) gemäß einem der vorhergehenden Ansprüche,
**dadurch gekennzeichnet, dass** der elektrische Isolator (3) aus Epoxidharzen, thermoplastischen Kunststoffen, Keramiken, Aluminiumoxid, Polyethylenen, Polyvinylchloriden, Polytetrafluorethylenen, Silikonen oder Glas besteht.

**8.** Solarzellenbaugruppe (1) gemäß einem der vorhergehenden Ansprüche,
**dadurch gekennzeichnet, dass** die Solarzelle (4) zumindest auf der mit der Sekundäroptik (5) verbundenen Seite zumindest eine Schutzbeschichtung aus einem optisch transparenten Metall, aus Aluminiumoxid, Silizium, Siliziumoxid, Siliziumnitrid, Siliziumcarbid, Polycarbonaten, Poly(meth)-acry-laten, Silikon, Glas, Quarzglas oder thermoplastischen Kunststoffen aufweist.

**9.** Solarzellenbaugruppe (1) gemäß einem der vorhergehenden Ansprüche,
**dadurch gekennzeichnet, dass** die refraktive Sekundäroptik (5) zur Fokussierung von Sonnenlicht auf der Solarzelle (4) umfassend ein aus einem optisch transparenten dielektrischen Material mit einer mittleren Transmittivität von mindestens 90 % im Wellenlängenbereich zwischen 400 und 2500 nm, gemessen bei einer Schichtdicke von 1 mm massiv ausgebildeten Refraktor, der eine dem Sonnenlicht zugewandte Eintrittsapertur (12) und eine der Solarzelle zugewandte Austrittsapertur (13) aufweist, wobei die Eintritts- (12) und/oder die Austrittsapertur (13) so ausgestaltet ist, dass eine refraktive Konzentration des
einfallenden Sonnenlichts erfolgt.

**10.** Solarzellenbaugruppe (1) gemäß Anspruch 9,
**dadurch gekennzeichnet, dass** das optisch transparente dielektrische Material für die Sekundäroptik (5) ausgewählt ist aus der Gruppe bestehend aus Epoxidharz, Silikon, Silikonharz, Polycarbonat, Polyacrylaten, Poly(meth)acrylaten, Glas, Quarzglas, thermoplastische Kunststoffen, Siliziumoxid, Siliziumcarbid, Aluminiumoxid und Mischungen hiervon.

**11.** Solarzellenbaugruppe (1) gemäß einem der Ansprüche 9 oder 10,
**dadurch gekennzeichnet, dass** die Eintritts- (12) und/oder Austrittsapertur (13) der Sekundäroptik (5) eine flache, konvexe und/oder konkave Oberflächenkontur aufweist.

**12.** Solarzellenbaugruppe (1) gemäß einem der Ansprüche 9 bis 11,
**dadurch gekennzeichnet, dass** die Fläche der Eintrittsapertur (12) der Sekundäroptik (5) größer ist als die Fläche der Austrittsapertur (13) der Sekundäroptik (5).

**13.** Solarzellenbaugruppe (1) gemäß einem der Ansprüche 9 bis 12,
**dadurch gekennzeichnet, dass** die refraktive Sekundäroptik (5) eine den Refraktor umschließende Auskragung (14) aufweist, die bevorzugt auf Höhe der Eintrittsapertur (12) angeordnet ist und weiter bevorzugt monolithisch oder formschlüssig mit dem Refraktor verbunden ist.

**14.** Solarzellenbaugruppe (1) gemäß Anspruch 13,
**dadurch gekennzeichnet, dass** der Refraktor mit Ausnahme der Bereiche der Eintritts- (12) und Austrittsapertur (13) und/oder die der Austrittsapertur (13) zugewandte Seite der Auskragung (14) mit einer hochreflektiven Beschichtung (15) mit einem Reflexionsgrad ρ > 70 % in einem Wellenlängenbereich von 400 bis 800 nm und/oder einem Reflexionsgrad p > 80 % in einem Wellenlängenbereich von 900 bis 2500 nm beschichtet ist.

15. Solarzellenbaugruppe (1) gemäß Anspruch 14, **dadurch gekennzeichnet, dass** die hochreflektive Beschichtung (15) der Sekundäroptik (5) ein Metall, insbesondere Aluminium, bevorzugt in hochreiner (> 99 Gew.-%) Form, oder Silber, und/oder eine Schichtfolge von Materialien mit unterschiedlichen Brechungsindices $n_D^{20}$ und/oder Legierungen enthält oder hieraus besteht.

16. Solarzellenbaugruppe (1) gemäß einem der Ansprüche 14 oder 15, **dadurch gekennzeichnet, dass** die hochreflektive Beschichtung (15) der Sekundäroptik (5) eine Schichtdicke von 1 nm bis 3 mm, bevorzugt von 1 μm bis 200 μm aufweist.

17. Solarzellenbaugruppe (1) gemäß einem der Ansprüche 9 bis 16, **dadurch gekennzeichnet, dass** der Refraktor mittels eines Verbunds (17) durch Verklebung und/oder mechanische Fixierung auf der metallisierten Oberfläche (7) fixiert ist.

18. Solarzellenbaugruppe (1) gemäß dem vorhergehendem Anspruch, **dadurch gekennzeichnet, dass** das Material für die Ausbildung des Verbunds (17) ausgewählt ist aus der Gruppe bestehend aus thermoplastischen Kunststoffen, Epoxidharzen, Silikonen, Acrylaten, Cyanacrylaten, Polycarbonaten, Polyacrylaten, Poly(meth)acrylaten und Mischungen hiervon.

19. Solarzellenbaugruppe (1) gemäß einem der Ansprüche 17 oder 18, **dadurch gekennzeichnet, dass** das Material für die Ausbildung des Verbunds (17) ein thermisch leitendes Material ist, das elektrisch isolierend ist.

20. Solarzellenbaugruppe (1) gemäß einem der Ansprüche 18 oder 19, **dadurch gekennzeichnet, dass** das Material für den Verbund (17) und das Kopplungsmedium (20) identisch sind.

21. Solarzellenbaugruppe (1) gemäß einem der Ansprüche 17 bis 19, **dadurch gekennzeichnet, dass** in Projektionsrichtung das Material für die Ausbildung des Verbunds (17) vollständig von der Auskragung (14) der Sekundäroptik (5) verdeckt ist.

22. Solarzellenbaugruppe (1) nach einem der Ansprüche 1 bis 12, **dadurch gekennzeichnet, dass** die refraktive Sekundäroptik (5) von einer Ummantelung (16) formschlüssig eingefasst ist, wobei die Oberseite der Ummantelung die Eintritts- (12) und die Unterseite der Ummantelung die Austrittsapertur (13) bildet.

23. Solarzellenbaugruppe (1) gemäß Anspruch 22, **dadurch gekennzeichnet, dass** die refraktive Sekundäroptik (5) eine konvex ausgebildete Eintrittsapertur (12) aufweist, die die Ummantelung (16) in Längsrichtung überragt.

24. Solarzellenbaugruppe (1) gemäß einem der Ansprüche 1 bis 23, **dadurch gekennzeichnet, dass** die Sekundäroptik (5) über mindestens ein Befestigungselement mit der Solarzelle (4) und/oder dem Substrat (2) verbunden ist.

25. Solarzellenbaugruppe (1) gemäß einem der Ansprüche 1 bis 24, **dadurch gekennzeichnet, dass** das Substrat (2) mindestens eine formschlüssige, reversible Arretierung aufweist, mit der mindestens ein Befestigungselement verbindbar ist.

26. Solarzellenbaugruppe (1) gemäß einem der Ansprüche 1 bis 25, **dadurch gekennzeichnet, dass** mindestens eine Schutzdiode und/oder mindestens eine Primäroptik zur Konzentration von Licht auf die Sekundäroptik (5), wie z.B. ein Fresnel-Kollektor, eine Linse und/oder ein Spiegel in der Solarzellenbaugruppe (1) enthalten ist.

27. Solarzellenbaugruppe (1) gemäß einem der Ansprüche 1 bis 26, **dadurch gekennzeichnet, dass** die Solarzelle (4) mit mindestens einer weiteren Solarzelle über den mindestens einen Kontakt elektrisch seriell und/oder parallel verschaltet ist.

28. Sollarzellenanordnung, **dadurch gekennzeichnet, dass** sie aus 2 bis 10.000 Solarzellenbaugruppen gemäß einem der Ansprüche 1 bis 27 aufgebaut ist.

FIG.1

FIG.2

FIG.3

**EP 2 278 631 A1**

## EUROPÄISCHER RECHERCHENBERICHT

Nummer der Anmeldung

EP 09 00 9379

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 5 167 724 A (CHIANG CLEMENT J [US]) 1. Dezember 1992 (1992-12-01) | 1-12, 17-20, 26-28 | INV. H01L31/052 |
| Y | * Spalte 5, Zeile 16 - Spalte 9, Zeile 55; Abbildungen 1-5 * ----- | 13-16, 21-25 | |
| Y | US 4 830 678 A (TODOROF WILLIAM J [US] ET AL) 16. Mai 1989 (1989-05-16) * Spalte 3, Zeile 4 - Spalte 7, Zeile 23; Abbildungen 1,2 * ----- | 13-16, 21-25 | |
| A | US 2009/120500 A1 (PRATHER ERIC [US] ET AL) 14. Mai 2009 (2009-05-14) * Absatz [0029] - Absatz [0050]; Abbildungen 1-7 * ----- | 1-28 | |
| A | US 2009/159128 A1 (SHOOK GILL [US] ET AL) 25. Juni 2009 (2009-06-25) * Absatz [0016] - Absatz [0031]; Abbildungen 1-5 * ----- | 1-28 | |

RECHERCHIERTE SACHGEBIETE (IPC)

H01L

Der vorliegende Recherchenbericht wurde für alle Patentansprüche erstellt

| Recherchenort | Abschlußdatum der Recherche | Prüfer |
|---|---|---|
| Berlin | 8. Dezember 2009 | Stirn, Jean-Pierre |

**ANHANG ZUM EUROPÄISCHEN RECHERCHENBERICHT
ÜBER DIE EUROPÄISCHE PATENTANMELDUNG NR.**

EP 09 00 9379

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-12-2009

| Im Recherchenbericht angeführtes Patentdokument | Datum der Veröffentlichung | Mitglied(er) der Patentfamilie | Datum der Veröffentlichung |
|---|---|---|---|
| US 5167724 A | 01-12-1992 | KEINE | |
| US 4830678 A | 16-05-1989 | KEINE | |
| US 2009120500 A1 | 14-05-2009 | WO 2009064625 A2 | 22-05-2009 |
| US 2009159128 A1 | 25-06-2009 | WO 2009086294 A2 | 09-07-2009 |

EPO FORM P0461

Für nähere Einzelheiten zu diesem Anhang : siehe Amtsblatt des Europäischen Patentamts, Nr.12/82